Europäisches Patentamt

European Patent Office

Office européen des brevets

(11) Veröffentlichungsnummer: **0 463 547 A2**

# EUROPÄISCHE PATENTANMELDUNG

(21) Anmeldenummer: **91110007.1**

(51) Int. Cl.5: **H05K 7/14**

(22) Anmeldetag: **19.06.91**

(30) Priorität: **27.06.90 DE 4020366**

(43) Veröffentlichungstag der Anmeldung:
**02.01.92 Patentblatt 92/01**

(84) Benannte Vertragsstaaten:
**CH FR GB IT LI**

(71) Anmelder: **FRIEDRICH LÜTZE ELEKTRO GESELLSCHAFT MIT BESCHRÄNKTER HAFTUNG**
**Bruckwiesenstrasse 17-19**
**W-7056 Weinstadt 3(DE)**

(72) Erfinder: **Hoffmann, Gerhard**
**Am Buchenrain 4**
**W-7150 Backnang(DE)**

(74) Vertreter: **Jackisch, Walter, Dipl.-Ing. et al**
**Patentanwalt W. Jackisch & Partner**
**Menzelstrasse 40**
**W-7000 Stuttgart 1(DE)**

(54) Gehäuse zur Aufnahme von mit elektronischen Bauteilen bestückbaren Steckkarten.

(57) Es soll ein Gehäuse geschaffen werden, in welches Steckkarten leicht eingesetzt und wieder herausgenommen werden können, die elektronischen Bauelemente leicht zugänglich sind und das im Bedarfsfall an die jeweils gewünschte Bestückung der Steckkarten mit elektronischen Bauteilen anpaßbar ist. Hierzu ist das Gehäuse (24) mit mehreren Führungen (10, 11) versehen, die übereinander liegen, bei denen die Einschuböffnungen (25) für die Steckkarten mit einer leicht abnehmbaren Abdeckung (1) versehen sind. Derartige Gehäuse werden in Schaltschränken, bei elektronisch gesteuerten Maschinen usw. angewandt.

Fig. 1

Die Erfindung betrifft ein Gehäuse zur Aufnahme mindestens einer mit elektronischen Bauteilen, beispielsweise Potentiometer, RC-Glieder, Kondensatoren usw., bestückbaren Steckkarte, die mittels Führungen in den Gehäuseseitenwänden durch mindestens eine Einschuböffnung einschiebbar ist.

Ein bekanntes Gehäuse dieser Art ist containerartig ausgeführt und besitzt nur an einer Seite die Einschuböffnung für die mit den elektronischen Bauteilen bestückte Steckkarte. Nachteilig ist bei dieser Ausführung, daß Steckkarten, die nicht die Länge des Gehäuses aufweisen, in den Führungen eingeklebt oder mit einer Kunstharzmasse derart vergossen werden, daß zugleich die Einschuböffnung abgeschlossen ist. Die Führungen bestehen bei dieser bekannten Ausführung aus einem in der Einschubebene liegenden Paar von Nuten, die in gegenüberliegenden Gehäusewänden vorgesehen sind. Leiterplatte und Gehäuse sind infolge der festen Verbindung zwischen Leiterplatte und Gehäuse ein kompakter Teil, der im wesentlichen nur einem bestimmten Verwendungszweck angepaßt ist und bei dem die Demontage bei etwaigen Reparaturen oder Schaltungsänderungen sehr erschwert ist. Ein erheblicher Nachteil der kompakten, in sich geschlossenen Bauweise ist die mangelnde Zugänglichkeit zur Steckkarte, auch Leiterplatte genannt, und den darauf befindlichen Bauelementen, wenn das Gehäuse samt Steckkarte betriebsfertig als geschlossene Baueinheit ausgeführt sind.

Aufgabe der Erfindung ist es, ein Gehäuse der oben erwähnten Art so auszuführen, daß sich die Steckkarten zwecks Montage oder Demontage leicht ein- und ausbauen lassen, wobei eine leichte Zugänglichkeit zu den eingesetzten Steckkarten und ihren Bauelementen gewährleistet sein soll. Darüber hinaus soll das Gehäuse so ausgebildet sein, daß es dem Bedarfsfall hinsichtlich der in ihm unterzubringenden Steckkartenzahl, Länge und deren Bestückung mit elektronischen Teilen leicht angepaßt werden kann.

Diese Aufgabe wird bei einem Gehäuse mit den eingangs erwähnten Merkmalen durch die im Kennzeichen des Anspruchs 1 genannten Merkmale gelöst. Dadurch daß die Führungen für die Steckkarten in mehreren übereinanderliegenden Ebenen angeordnet sind und zum Verschließen einer oder zweier sich gegenüberliegender Einschuböffnungen eine leicht abzunehmende Abdeckung vorgesehen ist, läßt sich das Gehäuse je nach dem Bedarfsfall mit einer oder mehreren übereinanderliegenden Steckkarten pro Abdeckung bestücken, wobei die Steckkarten ebenfalls je nach Bedarfsfall sowohl nach Zahl und Größe unterschiedliche elektronische Bauteile aufnehmen können. Weist beispielsweise die Steckkarte verhältnismäßig hohe Bauteile auf, kann diese unter Ausnutzung des Gehäuseraumes im unteren Bereich des Gehäuses, sozusagen in einer unteren Etage, eingeschoben werden, während raumsparend elektronische Bauteile auf der Steckkarte den Einschub mehrerer übereinanderliegender Steckkarten ermöglichen. Dadurch daß die Einschuböffnung oder -öffnungen durch vom Gehäuse getrennte besondere Bauteile, nämlich die Abdeckungen verschlossen werden, die zudem jederzeit leicht abnehmbar sind, kann die Bestückung des Gehäuses mit Steckkarten ohne Montageaufwand an den geänderten Bedarfsfall angepaßt werden.

Zur leichten Auswechselbarkeit der Steckkarten sieht die Erfindung ferner vor, daß die Abdeckungen Rastelemente für die Steckkarten aufweisen, beispielsweise Rastnocken, denen entsprechende Rastelemente, beispielsweise Rastausnehmungen, in den Steckkarten selbst zugeordnet sind, so daß die Steckkarte außer in den Führungen zusätzlich mit diesen Rastelementen positioniert ist. Weiter ist es für die einfache Zugänglichkeit zu den im Gehäuse befindlichen Steckkarten von Vorteil, wenn auch die Abdeckung Verankerungen, beispielsweise Rasthaken, aufweist, derart, daß nach Aufschieben der Abdecköffnung auf das Gehäuse die Abdeckung mit dem Gehäuse fest verbunden, jederzeit aber wieder lösbar ist.

Nach einem weiteren Merkmal der Erfindung weist die Abdeckung bzw. bei Anordnung zweier Abdeckungen beide Abdeckungen Durchbrüche auf, welche sowohl eine leichte Zugänglichkeit zu den elektronischen Bauteilen beispielsweise mittels Schraubenzieher und eine definierte Zuordnung beispielsweise von Drähten zu den Bauteilen oder dgl. ermöglicht.

Weitere Ausbildungen und Vorteile ergeben sich aus Unteransprüchen, der Beschreibung eines Ausführungsbeispieles und der Darstellung dieses in den Zeichnungen. Es zeigen:

Fig. 1    das Gehäuse mit zwei gegenüberliegenden Einschuböffnungen, die durch Abdeckungen geschlossen sind in perspektivischer Darstellung;

Fig. 2    das Gehäuse in Ansicht senkrecht zur Einschubrichtung für die Steckkarten gesehen;

Fig. 3    eine Draufsicht auf das Gehäuse, das auf der Oberseite mit einer Schwalbenschwanzaufnahme und Hutschiene versehen ist;

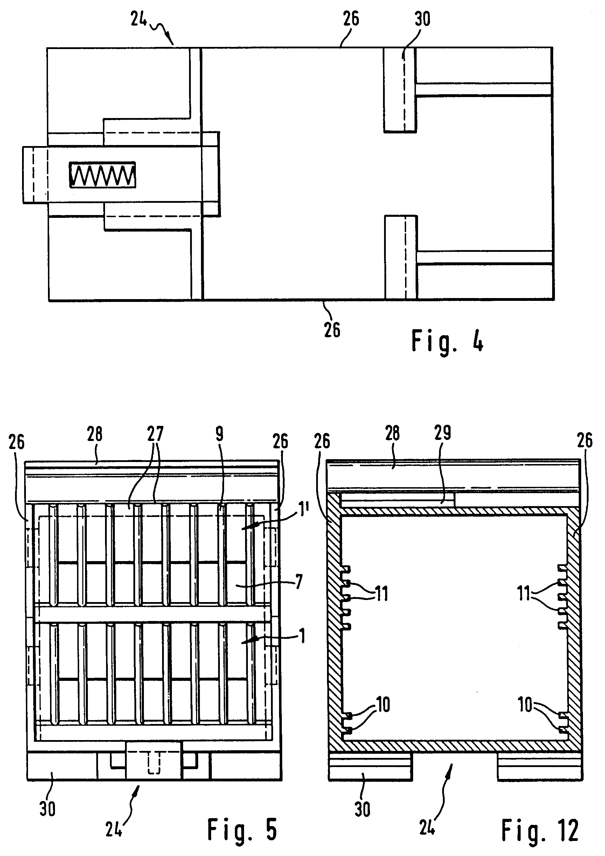

Fig. 4    eine Ansicht auf das Gehäuse von unten;

Fig. 5    eine Ansicht in Einschubrichtung A auf das mit zwei Abdeckungen versehene Gehäuse;

Fig. 6    eine Ansicht einer Abdeckung in Einschubrichtung A, also von vorn;

Fig. 7    eine Abdeckung in Ansicht II der Fig. 6;

Fig. 8 eine Draufsicht auf die Abdeckung nach Fig. 6 und 7;

Fig. 9 die Abdeckung nach Fig. 6 von rückwärts, also entgegen der Einschubrichtung A;

Fig. 10 einen Schnitt nach Linie B-B der Fig. 9;

Fig. 11 einen Schnitt nach Linie A-A der Fig. 9 mit abgebrochen gezeichneter, eingerasteter Leiterplatte;

Fig. 12 einen Schnitt durch die Mittelebene des Gehäuses nach Fig. 2.

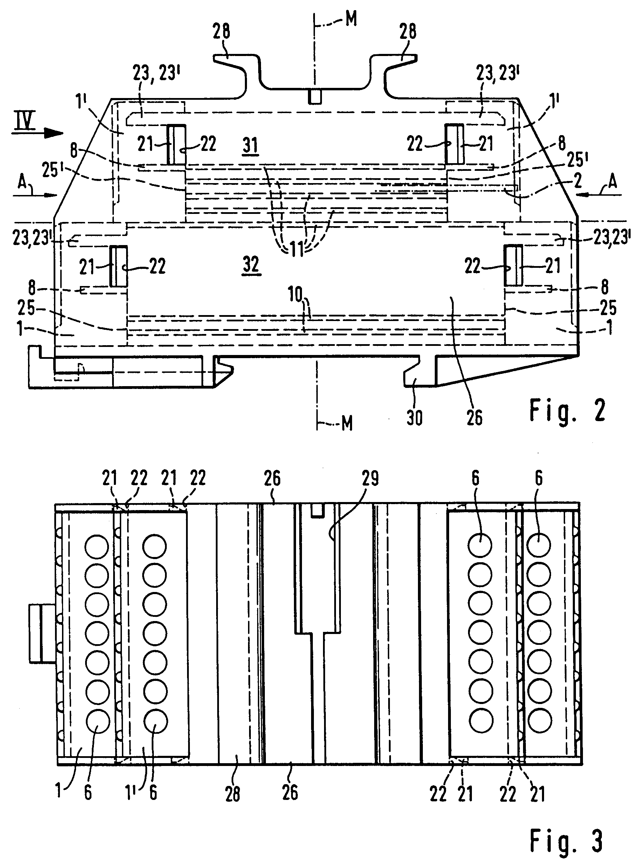

Bei dem Ausführungsbeispiel hat das Gehäuse 24 zwei Gehäusefächer, nämlich ein unteres 32 und ein oberes 31. Jedes Gehäusefach hat paarweise angeordnete Führungen 10, 11. Diese Führungen 10, 11 haben unterschiedliche Längen. Im unteren Gehäusefach 32 befinden sich zwei Paar übereinanderliegende Führungen 10 und im oberen Fach 31 vier übereinanderliegende Führungen 11, die gleichfalls paarweise angeordnet sind, so daß zwei übereinanderliegende Etagen zur Aufnahme von Steckkarten 2 im Gehäuse vorgesehen sind. Die Führungen sind im Ausführungsbeispiel als in das Gehäuse vorspringende Führungsschienen ausgebildet, auf welchen die eingeschobenen Steckkarten (Leiterplatten) aufsitzen. Selbstverständlich kann das Gehäuse 24 auch nur mit einem Fach und einer Mehrzahl, dem Bedarfsfall angepaßter Führungen 10, 11 ausgebildet sein. Es ist auch eine Ausführung denkbar, bei der mehr als zwei Gehäusefächer zur Aufnahme gleicher oder unterschiedlich langer Steckkarten 2 vorgesehen sind. Anstelle von Führungsschienen 10, 11, die in den Gehäuseinnenraum vorspringen, sind auch Führungen 10, 11 in Form von Nuten in den Gehäuseseitenwänden 26, 26 denkbar. Die Steckkarten 2 werden in Richtung A in das untere 32 bzw. obere Gehäusefach 31 eingeschoben. Senkrecht zur Einschubrichtung A der Steckkarten 2 gesehen, sind die Führungsschienen 10, 11 im oberen Fach 31 kürzer als im unteren Fach 32 gehalten. Demgemäß sind auch die beiden Gehäusefächer 32, 31 unterschiedlich lang ausgebildet, derart, daß das Gehäuse im unteren Teil im Grundriß etwa rechteckige Form und im oberen Teil im Grundriß mindestens annähernd trapezförmig ausgebildet ist. Vorteilhaft ist das Gehäuse 24 symmetrisch zu einer senkrecht zur Einschubrichtung liegenden Mittelebene M-M (vgl. Fig. 2) gestaltet. Auf der Oberseite des Gehäuses 24 können zwecks Zusammenbaus mit übereinanderliegenden gleichartigen Gehäusen 24 oder mit anderen Bauteilen eine Hutschiene 28 und/oder zum Beispiel eine Schwalbenschwanzaufnahme 29 und auf der Unterseite des Gehäuses 24 eine Rastschiene 30 ebenfalls zum Zusammenbau mit anderen Bauteilen vorgesehen sein.

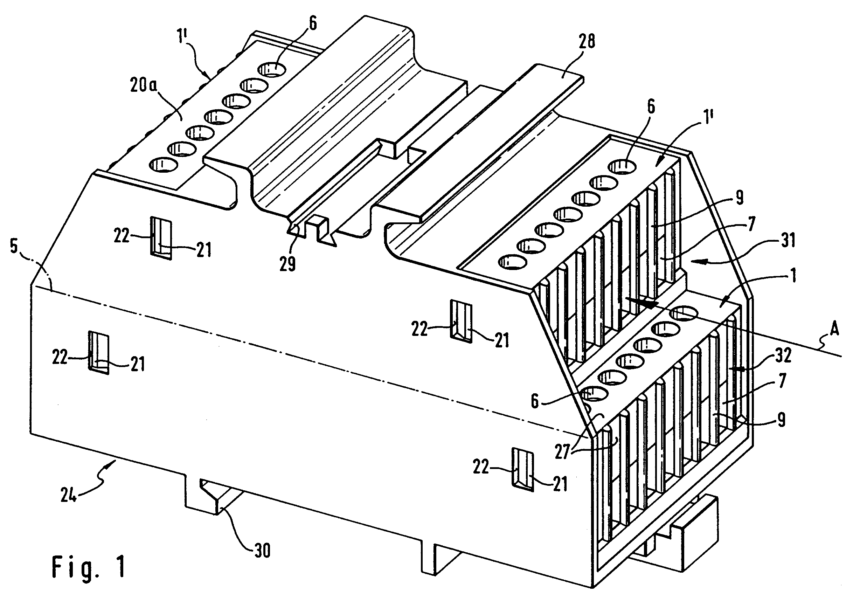

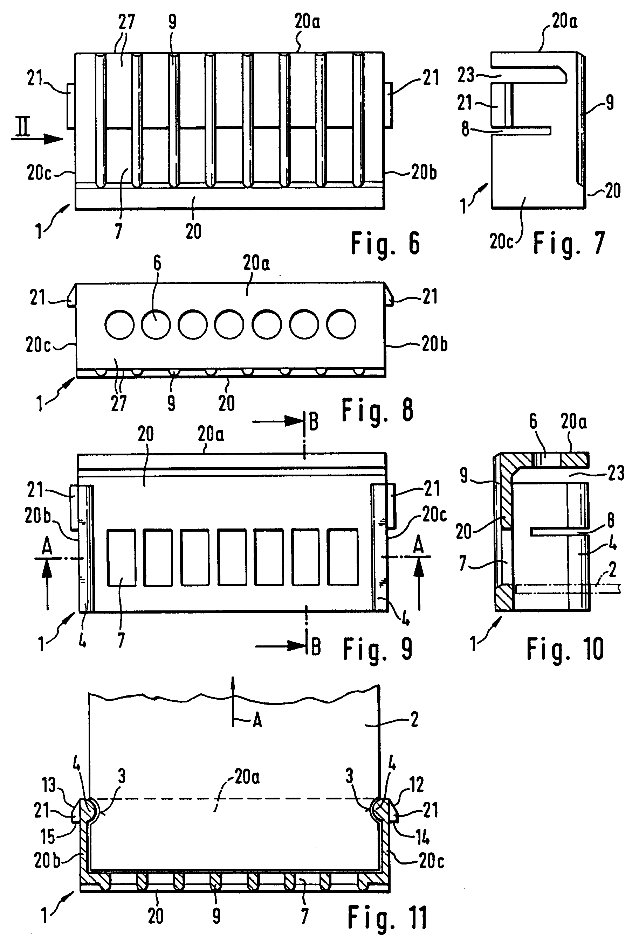

Zum Einschieben der Steckkarten 2 sind beim Gehäuse 24 für das untere Gehäusefach 32 zwei einander gegenüberliegende Einschuböffnungen 25 und für das obere Gehäusefach 31 ebenfalls die übereinanderliegenden Einschuböffnungen 25' vorgesehen. Jeder Einschuböffnung 25, 25 bzw. 25', 25' ist im Ausführungsbeispiel je eine Abdeckung 1, 1 bzw. 1', 1' zugeordnet. Diese Abdeckungen sind grundsätzlich gleich ausgebildet. Es sind Ausführungen denkbar, bei denen die Einschuböffnung durch zwei oder mehrere nebeneinander liegende kleinere Abdeckungen abgedeckt sind. Auch ist eine Ausführung möglich, bei der beispielsweise die übereinanderliegenden Einschuböffnungen 25, 25' durch eine einteilige ganze Abdeckung abgedeckt sind. Beim Ausführungsbeispiel sind, wie beschrieben, für das obere und für das untere Fach 31 bzw. 32 des Gehäuses 24 getrennte Abdeckungen 1, 1 bzw. 1', 1' vorgesehen. Wesentlich ist jedoch, daß bei dem Gehäuse 24 zur Aufnahme mindestens einer mit elektrischen Bauelementen, wie beispielsweise RC-Glieder, Kondensatoren usw. bestückbaren Steckkarte 2, die in den Führungen 10, 11 der Gehäuseseitenwände 26, 26 durch mindestens eine im Gehäuse 24 vorgesehene Einschuböffnung 25 bzw. 25' einschiebbar ist, die Führungen, beispielsweise in Form von Führungsschienen 10, 11, in mehreren übereinanderliegenden Ebenen im Gehäuse 24 angeordnet sind, wobei zum Verschließen dieser Einschuböffnungen 25, 25' mindestens eine abnehmbare Abdeckung 1 bzw. 1' vorgesehen ist. Diese Abdeckung 1 ist nun erfindungsgemäß so ausgebildet, daß sie einerseits eine einfache Positionierung und Aufnahme der Steckkarten 2 ermöglicht und andererseits gleichzeitig Rastmittel hat, durch welche die Abdeckung 1 schnell und einfach auf das Gehäuse aufgesetzt und wieder abgenommen werden kann. Bei einer bevorzugten Ausführung weist die Abdeckung Rastelemente, beispielsweise Rastnocken 4, auf, die mit Rastelementen der Steckkarten 2, beispielsweise Rastausnehmungen 3, derart zusammenwirken, daß die Steckkarten 2 unabhängig von ihrer Lage in den Führungsschienen 10 oder 11 von diesen Rastnocken in der jeweiligen Abdeckung 1 verrastet werden und dadurch in ihrer Lage im Gehäuse und in bezug auf die Abdeckung 1 positioniert sind. Vorzugsweise sind die Rastnocken 4 für die Aufnahme der Rastausnehmungen 3 der Steckkarten 2 senkrecht zur Einschubrichtung A angeordnet, und zwar so, daß sie sich in ihrer Länge über den Bereich der übereinanderliegenden Führungsschienen 10 bzw. 11 erstrecken. Hierdurch ist es möglich, daß beim Aufschieben der Abdeckungen 1 auf das Gehäuse 24 die im Gehäuse schon befindlichen Steckkarten 2 sicher und ohne daß besondere Manipulationen erforderlich sind, durch die Rastnocken 4 in Verbindung mit den Rastausnehmungen 3 in den Steckkarten 2 in ihrer Lage positioniert und mit den Abdeckungen 1 verrastet sind. Ein weiteres wesentliches Merkmal in der Ausbildung der Abdeckungen liegt darin, daß diese Abdeckungen 1 Verankerungen haben, beispielsweise Rasthaken 21, mittels welcher sie im Gehäuse 24 gehaltert sind. Zu diesem Zwecke sind im Gehäuse 24 Verankerungen, beispielsweise Rastfenster 22, vorgesehen, die mit diesen Rasthaken 21 korrespondieren und in den sich gegenüberliegenden Seitenwänden 26 des Gehäuses angeordnet sind. Bei der im Ausführungsbeispiel dargestellten bevorzugten Ausführungsform sind die Abdeckungen 1 für alle Einschuböffnungen gleich ausgebildet, und zwar, winkelig in einem Querschnitt parallel zur Einschubrichtung A der Steckkarten 2 gesehen, etwa U-förmig, wobei diese winkelige Abdeckung 1 senkrecht zu ihrer Frontfläche 20 befindliche Seitenflächen 20b, 20c und eine Deckfläche 20a aufweist. Dabei sind vorteilhaft die Rasthaken 21 in den Seitenflächen 20b und 20c der Abdeckung 1 in Einschubrichtung A der Steckkarten 2 gesehen im vorderen Bereich der Seitenflächen 20b und 20c angeordnet und nach außen gerichtet. Die Rasthaken 21, 21 (vgl. Fig. 11) weisen dabei in Einschubrichtung A der Steckkarte 2 gesehen sich verjüngende Auflaufschrägen 12, 13 auf, die ein einfaches Einschieben der Abdeckungen 1 in die Gehäuseseitenwände 26 ermöglichen, und haben ferner in Einschubrichtung A gesehen hinter diesen Auflaufschrägen 12, 13 senkrecht zur Einschubrichtung A gesehen Rastflächen 14, 15, die sich im eingerasteten Zustand der Abdeckungen 1 gegen die entsprechenden Kanten der Rastfenster 22 des Gehäuses 24 legen (vgl. Fig. 1). Um das Einschieben der Abdeckungen 1 und die Verrastung der Rastelemente, im Ausführungsbeispiel Rasthaken 21, und der zugeordneten Verankerungen, nämlich im Ausführungsbeispiel die Rastfenster 22, zu ermöglichen, sind in weiterer Ausbildung die Seitenflächen 20b, 20c der Abdeckungen 1 mit Schlitzen 23, 8 versehen. Diese Schlitze liegen in Einschubrichtung A gesehen im vorderen Bereich der Seitenflächen 20b, 20c und sind in Einschubrichtung A gesehen vorne offen. Hierdurch erhalten die Seitenflächen 20b, 20c eine erwünschte Elastizität oder Nachgiebigkeit, so daß beim Einschieben der Abdeckung 1 die Seitenteile 20b, 20c beim Gleiten mit den Auflaufschrägen 12, 13 an den Innenseiten des Gehäuses 24 entlang nach innen federnd ausweichen können, so daß diese Abdeckungen 1 bequem eingeschoben werden können und nach Einrasten der Rasthaken 21 in die Fenster 22 eine sichere und selbsttätige Verrastung infolge Rückfederung der Seitenflächen 20b, 20c erfolgt. Der Schlitz 23 dient gleichzeitig zur Positionierung der Abdeckung 1 beim Einschieben. Ihm ist jeweils eine entsprechende Wulst 23', die in diesen Schlitz 23 eingreift, auf den Innenseiten des Gehäuses zugeordnet. Diese Wulst hat eine etwas kleinere Dicke als der Schlitz breit ist, so daß sich der Wulst beim Einschieben der Abdeckung 1 leicht in den Schlitz 23 einfädeln kann. Hierdurch wird die Abdeckung 1 bereits bei ihrem Aufsetzen auf das Gehäuse in die richtige Lage gebracht und bleibt während des Einschiebevorganges in dieser positioniert. Der Schlitz 8 dient ausschließlich der Erhöhung der seitlichen Beweglichkeit, also der besseren federnden Ausbildung der Seitenflächen 20b, 20c. Die Schlitze 23 sichern somit gleichzeitig auch das automatisch Einrasten der Rasthaken 21 in die Gehäuseöffnungen 22. Die federnden Seitenflächen 20b, 20c ermöglichen somit auch beim Ausbau der Leiterplatten 2 eine einfache Lösung der Verbindung zwischen Gehäuse 24 und Abdeckung 1, da die Rastnocken 21 leicht soweit nach innen gedrückt werden können, bis die Rasthaken 21 die Anlageflächen der Rastfenster 22 überwunden haben. Danach läßt sich die Abdeckung 1 samt Leiterplatte 2 bzw. Leiterplatten entgegen der Richtung A herausziehen. Mit dieser Verrastung sind nicht nur die Abdeckungen 1 fest mit dem Gehäuse selbst zu einer Einheit verbunden; gleichzeitig werden die Steckkarten 2, die auf den Führungsschienen 10 bzw. 11 auflagern, in dieser Lage infolge der vorgesehenen Rastnocken 4 in Verbindung mit den Rastausnehmungen 3 in den Steckkarten 2 positioniert. Nach dem Einschieben der Steckkarten 2 in die Führungsschienen 10 bzw. 11, der Verrastung zwischen den Rastelementen 4, 3 und der Verrastung der Rastelemente 21, 21 in den Rastfenstern 22, 22 des Gehäuses 24 sind die Steckkarten mit ihren elektrischen Bauelementen und das ganze Gehäuse fest miteinander verbunden, wobei durch diese Anordnung und Ausbildung eine sichere Halterung, beispielsweise gegen Dauerschwingungen bei Einbringen des Gehäuses mit den Leiterplatten in einen rüttelnden oder schwingenden Bauteil, gewährleistet ist.

Eine weitere sehr vorteilhafte Ausbildung erhält das Gehäuse mit Abdeckungen 1 dadurch, daß die Frontfläche 20 der Abdeckung 1 und die Deckfläche 20a mehrere nebeneinanderliegende, entsprechend dem Bedarfsfall, beispielsweise kreis- oder rechteckförmig ausgebildete Durchbrüche 6, 7, aufweist. Dabei sind die Durchbrüche 6 vorteilhaft in der Deckfläche 20a vorgesehen, um beispielsweise mittels eines Schraubenziehers, einen sicheren und einfachen Zugang zu den auf der Steckkarte 2 befindlichen Bauelementen zu haben. Die Durchbrüche oder Ausnehmungen 7 in der Frontfläche 20, die (vgl. Fig. 9) im Gegensatz zu den runden Durchbrüchen oder Ausnehmungen 6 beispielsweise rechteckförmig ausgebildet sein können, ermöglichen einen einfachen Zugang von der Einschubseite her zu den Bauelementen der Leiterplatte und können zur Durchführung etwaiger Kabelanschlüsse, Drähte usw. benutzt werden. Die Anordnung ist dabei in der Frontfläche so getroffen, daß oberhalb der Durchbrüche 7 auf der Frontfläche 10 und der Deckfläche 20a Beschriftungsflächen 27 verbleiben. Diese Beschriftungsflächen 27 können, um sie den jeweiligen Frontdurchbrüchen 7 klar zuzuordnen, optisch deutlich erkennbar voneinander getrennt sein, indem die Zwischenflächen zwischen den Frontdurchbrüchen 7 beispielsweise durch Stege 9 voneinander abgegrenzt sind. Dabei grenzen diese Stege 9, weil sie durchgehend ausgebildet sind, außer den Beschriftungsflächen 27 gleichzeitig auch die Durchbrüche 7 deutlich voneinander ab. Wie erwähnt, ist das Gehäuse 24 in ein unteres Gehäusefach 32 und ein oberes Gehäusefach 31 aufgeteilt, wobei die Trennungsebene in Fig. 1 durch die strichpunktierte Linie 5 angedeutet ist. Durch diesen Aufbau des Gehäuses kann eine optimal große Zahl von Leiterplatten in ein- und demselben Gehäuse untergebracht werden. Das beschriebene Gehäuse samt Abdeckungen und Leiterplatten läßt sich in einfacher Weise den verschiedensten Anforderungen anpassen. Je nach Bauhöhe der Bauelemente auf der Steckkarte (Leiterplatte) können eine oder mehrere Leiterplatten gleicher, aber auch unterschiedlicher Länge im Gehäuse untergebracht werden. Beim beschriebenen Ausführungsbeispiel kann eine Leiterplatte beispielsweise bis zu vierzehn Anschlußklemmen, Potentiometer oder Leuchtdioden aufweisen, was beispielsweise in der Motorschutztechnik besonders wichtig ist. Die Verbindung des Gehäuses 24 mit den Steckkarten 2 und der Abdeckung 1 ausschließlich über Rastelemente ermöglicht einen einfachen und schnellen Ein- und Ausbau der Steckkarten, wobei gleichzeitig eine sichere Arretierung der Steckkarten im Gehäuse gegeben ist. Für die Halterung und Fixierung der Leiterplatten sind die bisherigen Klebe- und Vergießtechniken entbehrlich. Die von der Leiterplatte getragenen elektronischen oder elektrischen Bauelemente können je nach Bedarfsfall leicht und schnell ausgewechselt werden. Darüber hinaus ist durch die Ausgestaltung des Gehäuses sowie der Abdeckungen samt den vorgesehenen Durchbrüchen, die in ihrer geometrischen Form den Bedürfnissen angepaßt sein können, jederzeit ein leichter Zugang zu den Leiterplatten und ihren Teilen gewährleistet, wobei je nach Bauhöhe der elektronischen Teile auf der Leiterplatte ein oder mehrere Leiterplatten in verschiedenen Höhenlagen je nach Bedarf untergebracht werden können. Dabei können auch unterschiedlich lange Leiterplatten im Gehäuse jederzeit montiert werden. Dies ist möglich, weil die Rastnocken 4 über die Höhe des Bereiches der Führungsschienen 10, 11 reichen und somit in unterschiedlicher Höhe befindliche Leiterplatten mittels der Ausnehmungen 3 in diesen formschlüssig aufnehmen und in der verrasteten Lage halten. Dadurch sind die Leiterplatten in der Einbaulage von ihrer Länge und der Höhe der auf ihnen befindlichen elektronischen Bauteile unabhängig. Die in den Abdeckungen 1 vorgesehenen Öffnungen 6 bzw. 7, deren Achsen senkrecht zueinander liegen, können auch der Bestückung der Leiterplatten in ihrer Form angepaßt werden, so daß eine eindeutige Zuordnung dieser Öffnungen zu den elektronischen Bauteilen, beispielsweise Anschlußklemmen, Potentiometern, LED's usw. besteht und darüber hinaus beispielsweise die Anschlüsse zu diesen Teilen auf kürzestem Wege herausgeführt werden können und gleichzeitig eine leichte Zugänglichkeit, zum Beispiel mittels Schraubenzieher oder dgl., gewährleistet ist. Die Ausbildung der Rastmittel in Abdeckung 1 und Gehäuse 24 erspart die Anwendung ein- für allemal festgelegter fester Verbindungen, die nicht mehr lösbar sind, und gibt somit dem Gehäuse eine große Anwendungsvariabilität. Das beschriebene Gehäuse mit oberem und unterem Fach 31 bzw. 32 mit den getrennten Abdeckungen 1 für jedes Gehäusefach ist eine bevorzugte Ausführungsform, bei der auf minimalem Platz eine maximale Anzahl von Leiterplatten untergebracht werden kann. Die bei dieser Ausführung vorgesehenen vier Abdeckkappen können mit Markierungen, beispielsweise durch entsprechende Farbgebung, versehen sein, welche die genaue Zuordnung der Abdeckkappen und damit der jeweiligen Leiterplatten 2 zu den einzelnen Fächern des Gehäuses festlegt, wodurch eine erhebliche Vereinfachung bei der Montage gegeben ist.

**Patentansprüche**

1.   Gehäuse zur Aufnahme mindestens einer mit elektrischen Bauelementen, beispielsweise RC-Glieder, Kondensatoren oder dgl., bestückbaren Steckkarte, die in Führungen der Gehäuseseitenwände durch mindestens eine im Gehäuse vorgesehene Einschuböffnung einschiebbar ist,
dadurch gekennzeichnet, daß die Führungen (10, 11) in mehreren übereinanderliegenden Ebenen angeordnet sind und daß zum Verschließen der Einschuböffnung (25) mindestens eine abnehmbare Abdeckung (1) vorgesehen ist.

2.   Gehäuse nach Anspruch 1,
dadurch gekennzeichnet, daß die Abdeckung (1) Rastelemente, beispielsweise Rastnocken (4), für die Steckkarten (2) aufweist, denen entsprechende Rastelemente, beispielsweise Rastausnehmungen (3), der Steckkarten (2) zugeordnet sind.

**3.** Gehäuse nach einem der Ansprüche 1 oder 2, dadurch gekennzeichnet, daß die Abdeckung (1) Verankerungen, beispielsweise Rasthaken (21), für ihre Halterung im Gehäuse (24) aufweist, denen entsprechende Verankerungen, beispielsweise Rastfenster (23), in den Seitenwänden (26) des Gehäuses (24) zugeordnet sind, wobei die Rasthaken (21) in Einschubrichtung (A) gesehen im vorderen Bereich der Seitenflächen (20b, 20c) liegen und nach außen gerichtet sind.

**4.** Gehäuse nach einem der Ansprüche 1 bis 3, dadurch gekennzeichnet, daß die Abdeckung (1) winkelig, vorzugsweise senkrecht, zu ihrer Frontfläche (20) angeordnete Seitenflächen (20b, 20c) sowie eine Deckfläche (20a) aufweist, wobei die Frontfläche (20) und/oder die Deckfläche (20a) mehrere nebeneinanderliegende, vorzugsweise kreis- und/oder rechteckförmige, Durchbrüche (6, 7) aufweist.

**5.** Gehäuse nach einem der Ansprüche 1 bis 4, dadurch gekennzeichnet, daß oberhalb der Durchbrüche (7) in der Frontfläche (20) und der Deckfläche (20a) Beschriftungsflächen (27) vorgesehen sind, die durch Stege (20d) voneinander abgegrenzt sind.

**6.** Gehäuse nach einem der Ansprüche 1 bis 5, dadurch gekennzeichnet, daß zur federnden Nachgiebigkeit der Seitenflächen (20b, 20c) in diesen wenigstens je ein in Einschubrichtung vorne offener Schlitz (23 bzw. 8) vorgesehen, wobei vorzugsweise der in Einschubrichtung nach vorne offene Schlitz (23) nach Breite und Länge derart dimensioniert ist, daß er in einer an der Innenseite ihm zugeordneten entsprechend dimensionierten Wulst (23') die Abdeckung (1) beim Einschieben in bezug auf die Rastmittel (21, 22) positioniert.

**7.** Gehäuse nach einem der Ansprüche 1 bis 6, dadurch gekennzeichnet, daß die Rastelemente (4), Rastausnehmungen (3), Rasthaken (21), Rastfenster (22), Einführungsschlitz (23) für die Abdeckung (1) und zugeordnete Wulste (23') in den Seitenflächen (26) des Gehäuses (24) sowie die Schlitze (8) zur Erhöhung der Nachgiebigkeit der Seitenflächen (20b, 20c) der Abdeckung (1) paarweise und symmetrisch zu der in Einschubrichtung (A) liegenden Mittelebene des Gehäuses vorgesehen sind.

**8.** Gehäuse nach einem der Ansprüche 1 bis 7, dadurch gekennzeichnet, daß die im Gehäuse (24) befindlichen Führungen (10, 11) unterschiedliche Längen haben und als Führungsschienen ausgebildet sind und daß vorzugsweise die Führungsschienen (10, 11) im Gehäuse (24) übereinanderliegend angeordnet sind.

**9.** Gehäuse nach einem der Ansprüche 1 bis 8, dadurch gekennzeichnet, daß die Rastnocken (4) für die Rastausnehmungen (3) der Steckkarten (2) senkrecht zur Einschubrichtung (A) angeordnet sind und sich in ihrer Länge über den Bereich der übereinanderliegenden Führungsschienen (10, 11) erstrecken.

**10.** Gehäuse nach einem dem Ansprüche 1 bis 9, dadurch gekennzeichnet, daß das Gehäuse (24) einander gegenüberliegende Einschuböffnungen (25) für Steckkarten (2) hat, wobei jeder Einschuböffnung mindestens eine Abdeckung (1) zugeordnet ist und daß das Gehäuse (24) symmetrisch zu einer senkrecht zur Einschubrichtung liegenden Mittelebene ausgebildet ist.

**11.** Gehäuse nach einem der Ansprüche 1 bis 10, dadurch gekennzeichnet, daß das Gehäuse (24) mindestens zwei Einschubfächer aufweist, wobei senkrecht zur Einschubrichtung (A) der Steckkarten (2) gesehen die Führungsschienen (10, 11) im oberen Fach (31) kürzer als im unteren Fach (32) sind und daß jedem Einschubfach (32, 31) je eine gleich ausgebildete Abdeckung (1) zugeordnet ist.

**12.** Gehäuse nach einem der Ansprüche 1 bis 11, dadurch gekennzeichnet, daß der obere Teil des Gehäuses entsprechend der kürzeren Ausbildung der Führungsschiene in seiner Längserstreckung kleiner als der untere Gehäuseteil gehalten ist, wobei vorzugsweise für das obere und für das untere Fach (31 bzw. 32) des Gehäuses (24) getrennte Abdeckungen (1) vorgesehen sind.

**13.** Gehäuse nach einem der Ansprüche 1 bis 12, dadurch gekennzeichnet, daß das Gehäuse (24) auf seiner Oberseite eine Hutschiene (28) sowie eine Schwalbenschwanzaufnahme (29) und auf seiner Unterseite eine Rastschiene (30) zum Zusammenbau mit anderen Bauteilen aufweist.

Fig. 1

Fig. 2

Fig. 3

Fig. 4

Fig. 5

Fig. 12

Fig. 6

Fig. 7

Fig. 8

Fig. 9

Fig. 10

Fig. 11